Europäisches Patentamt

**European Patent Office**

Office européen des brevets

(11) Publication number: **0 055 310**
A1

(12) # EUROPEAN PATENT APPLICATION

(21) Application number: 80304739.8

(22) Date of filing: 29.12.80

(51) Int. Cl.³: **C 01 B 33/02**

(43) Date of publication of application:
07.07.82 Bulletin 82/27

(84) Designated Contracting States:
AT BE CH DE GB IT LI LU NL SE

(71) Applicant: SEMIX INCORPORATED
15809 Gaither Road
Gaithersburg Maryland 20760(US)

(72) Inventor: Lindmayer, Joseph
6919 Blaisdell Road
Bethesda Maryland(US)

(74) Representative: Allard, Susan Joyce et al,
BOULT, WADE & TENNANT 27 Furnival street
London EC4A 1PQ(GB)

(54) Method and apparatus for the continuous casting of silicon.

(57) A method and apparatus for the continuous melting of silicon for use in semiconductor devices, the method tending to reduce the time and expense associated with conventional melting and forming. The method for melting silicon comprises charging silicon into a melting vessel having a drain therein, heating the silicon in the vessel to a temperature above the melting point of silicon, and allowing the molten silicon to pass through the drain out of the vessel.

1.

## METHOD AND APPARATUS FOR THE CONTINUOUS CASTING OF SILICON

The present invention relates generally to a method and apparatus for the melting and casting of silicon and silicon-containing materials, and is more particularly concerned with a method and apparatus for the continuous melting of silicon for use in semiconductor devices in order to reduce the time and expense associated with conventional melting and forming.

While the present invention will be primarily discussed herein with reference to the melting of silicon for use in semiconductor type devices, particularly photovoltaic cells, it will be understood that the applicability of the present invention is not thereby so limited.

In the conventional melting and forming of silicon for semiconductor use, it generally is the practice to charge a quartz vessel with pieces of silicon of various sizes and then heat the vessel under a protective gas blanket to a temperature sufficient to melt the silicon. The silicon is then formed into a monocrystalline rod by the Czochralski method, which is to seed the molten silicon and then slowly withdraw a formed rod from the molten silicon within the vessel. This method is generally quite time-consuming and requires expensive processing equipment.

We have previously proposed a method for forming silicon into a semicrystalline product in which method, silicon is melted within a melting vessel and then cooled under controlled conditions to produce a semicrystalline silicon product useful for the manufacture of photovoltaic cells. This method results in distinct cost advantages over the Czochralski method for producing silicon for photovoltaic cell uses.

However, several problems are associated with the above method for producing semicrystalline silicon for use in semiconductor devices such as photovoltaic cells. One problem is that it is often difficult to control the heating of the silicon to a temperature just exceeding the melting point of silicon of $1410^{\circ}C$. In order to ensure that all of the silicon is melted, and because it is difficult to accurately control the heating of the vessel at such elevated temperatures often the silicon is heated to a temperature in excess of its melting point, e.g., the temperature of the silicon may reach $1450^{\circ}C$ or above. Such heating of the silicon may cause harmful stresses within the vessel used to contain the molten silicon, may cause undesirable reactions between the silicon and the vessel, and increases the time necessary for the total operation of melting and forming the silicon.

In addition, because quartz and silicon have different coefficients of thermal contraction, upon solidification of the silicon it is a common occurrence for the vessel to crack or even break, thereby rendering the vessel unfit for further use. Quartz vessels for melting silicon are quite expensive, and as a consequence breakage of the vessels adds considerably to the overall cost of the semiconductor device made from silicon by conventional methods.

We have now developed a method and apparatus for the melting of silicon, which significantly reduces the possibility for excessively heating the silicon and its associated melting vessel, which reduces the possibility of breakage of the melting vessel, and thereby reduces the cost of the melting operation, which can be performed in a continuous manner and in which vessels of a relatively inexpensive material can be utilized.

Accordingly, the present invention provides a method for melting and casting silicon suitable for use as a host material for photovoltaic cells, comprising charging solid silicon into a melting vessel having an open drain therein, maintaining the melting vessel at substantially atmospheric pressure. applying heat to the solid silicon charge in the vessel so that initial portions thereof will be heated to a temperature above the melting point of silicon and become molten while other portions of the silicon charge remain in a solid state, allowing the molten silicon to pass through the drain out of the melting vessel without substantial obstruction at a temperature just above the melting point of the silicon, collecting the molten silicon in a receiving vessel at about said temperature so that the temperature of the collected silicon will be just above the melting point of silicon and the retention time of molten silicon in the melting vessel will be minimized, and solidifying the collected silicon in the receiving vessel.

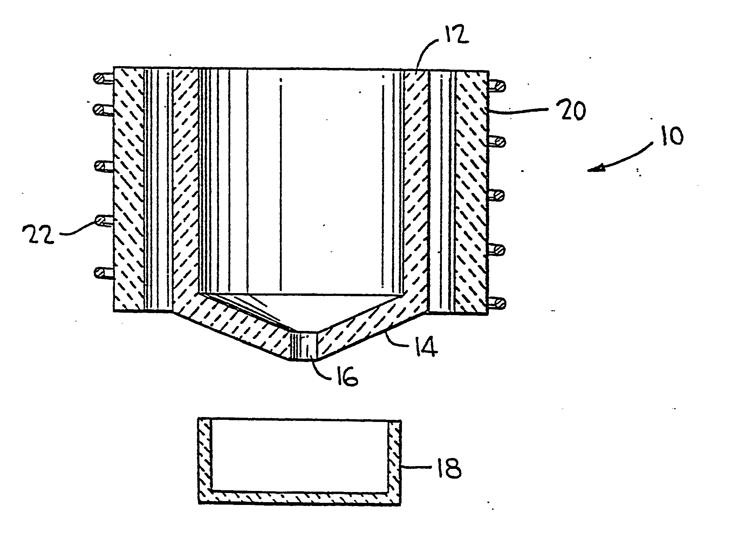

The present invention will be further described with reference to the accompanying drawing.

In the drawing, the sole Figure is a cross-sectional view of a vessel for containing molten silicon in accordance with the present invention.

Referring now to the sole Figure of the drawing, apparatus 10 includes melting vessel 12, surrounding heat source 20 and radio frequency coils 22. Vessel 12 in this embodiment is generally circular in shape and has a sloping bottom surface 14 with an open drain 16 therein. While quartz is generally the preferred material for vessel 12, the vessel may also be composed of considerably less expensive materials such as fired clay and the like, since contamination by impurities in such vessel materials is considerably reduced by the method of the present invention as will be explained hereinafter.

Located beneath drain 16 of melting vessel 12 is receiving vessel 18 which collects molten silicon flowing from the drain. Like melting vessel 12, receiving vessel 18 may be of quartz, clay or like material.

The method of melting silicon containing material
utilizing apparatus 10 includes charging pieces or chunks of
silicon into the vessel 12, and then heating the vessel and the
contents by coils 22. The charge silicon may be refined
silicon commonly referred to as "poly", or metallurgical
grade silicon having a greater amount of impurities than "poly"
-type silicon. While vessel 12 is being heated, silicon
containing material is protected from undesirable chemical
reactions by a non-oxidizing protective gas blanket.

As the silicon containing material reaches its melting
point of about $1410^{\circ}$ C., the silicon will melt and flow
down to the bottom or vessel 12 and out drain 16 into
receiving vessel 18 where it is allowed to solidify slowly
e.g., in accordance with the process of my aforementioned
application. The solidified body of semicrystalline silicon
may then be sliced into wafers for manufacture into
photovoltaic cells.

Since, in this method, the silicon flows from the vessel
as soon as it melts or shortly thereafter, any tendency
for the silicon to be overheated is thereby significantly
reduced. A further advantage of the present method and
apparatus is that as the amount of silicon in the vessel
12 is reduced due to the melted material flowing out drain 16.
further material can be charged into the vessel. Also,
receiving vessel 18 can be removed and replaced by another
empty receiving vessel after a predetermined quantity of
molten silicon has flowed into the first vessel. Thus the method and apparatus of the present invention is adapted for the continuous casting of silicon. A single melting vessel 12 may therefore be used for the melting of a volume of silicon greatly in excess of its own volume.

Moreover, since most if not all of the molten silicon will drain from vessel 12 upon completion of the casting cycle, the possibilities for vessel breakage due to solidification of silicon within the vessel during cooldown are significantly reduced if not eliminated.

As was mentioned previously, quartz type vessels are at present almost exclusively used for the conventional melting of silicon so as to minimize contamination of the material by the vessel. However, the present invention allows the use of other materials such as clay for vessel 12 since the residence time for the molten silicon is generally of a too short duration to allow significant material contamination by any impurities contained within the vessel. For similar reasons, receiver vessel 18 may also be made of materials other than quartz. Of course, the use of other materials for vessels 12 and 18 may provide significant cost reductions in the melting and casting of silicon due to the inexpensiveness of these other materials.

7. 0055310

CLAIMS

1. A method for melting and casting silicon suitable for use as a host material for photovoltaic cells, comprising charging solid silicon into a melting vessel having an open drain therein, maintaining the melting vessel at substantially atmospheric pressure, applying heat to the solid silicon charge in the vessel so that initial portions thereof will be heated to a temperature above the melting point of silicon and become molten while other portions of the silicon charge remain in a solid state, allowing the molten silicon to pass through the drain out of the melting vessel without substantial obstruction at a temperature just above the melting point of the silicon, collecting the molten silicon in a receiving vessel at about said temperature so that the temperature of the collected silicon will be just above the melting point of silicon and the retention time of molten silicon in the melting vessel will be minimized, and solidifying the collected silicon in the receiving vessel.

2. A method as claimed in claim 1 wherein the molten silicon is solidified while controlling the heat loss therefrom.

3. A method as claimed in claim 1 or claim 2 wherein the melting vessel is formed from a ceramic material.

4. A method as claimed in any one of the preceding claims wherein the receiving vessel is formed from a ceramic material.

5. A method as claimed in any one of the preceding claims wherein the charged silicon is metallurgical grade silicon.

6. An apparatus adapted for use in melting silicon, comprising a vessel formed from a material substantially inert to silicon at the melting point of silicon and capable of withstanding temperatures in excess of $1410^{\circ}C.$, the vessel having a drain therein.

7. An apparatus as claimed in claim 6 wherein the material of the vessel comprises a ceramic material.

8. An apparatus as claimed in claim 6 or claim 7, wherein the drain is continuously open for the passage of fluid therethrough by gravity.

9. An apparatus as claimed in claim 8 wherein the drain is located in the bottom of the vessel.

0055310

## DOCUMENTS CONSIDERED TO BE RELEVANT

| Category | Citation of document with indication, where appropriate, of relevant passages | Relevant to claim |
|---|---|---|
| X | <u>GB - A - 923 495</u> (ASSOCIATED ELECTRICAL INDUSTRIES)<br>* page 1, lines 54 to 79 *<br>-- | 1,3,<br>6-9 |
| | <u>GB - A - 2 005 650</u> (WESTINGHOUSE)<br>* claim 1; fig. 3 *<br>-- | 1,2,6,<br>8,9 |
| A | <u>WO - A1 - 80/01489</u> (CERES CORP.)<br>-- | |
| A | <u>US - A- 4 176 166</u> (J.N. CARMAN)<br>---- | |

**CLASSIFICATION OF THE APPLICATION (Int. Cl.³)**

C 01 B   33/02

**TECHNICAL FIELDS SEARCHED (Int. Cl.³)**

C 01 B   33/00

C 30 B   23/00

C 30 B   25/00

C 30 B   29/00

H 01 L   21/00

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons
&: member of the same patent family, corresponding document

The present search report has been drawn up for all claims

| Place of search | Date of completion of the search | Examiner |
|---|---|---|
| Berlin | 30-07-1981 | KESTEN |

EPO Form 1503.1   06.78